# EUROPEAN PATENT APPLICATION

(11) **EP 1 737 032 A1**
(43) Date of publication of application: **27.12.2006**
(21) Application number: 05720714.4
(22) Date of filing: 14.03.2005
(51) Int. Cl.: H01L 21/822, G05F 1/10, H01L 27/04

(54) **SEMICONDUCTOR INTEGRATED CIRCUIT DEVICE AND SWITCHING POWER SOURCE DEVICE USING THE SAME**

(30) Priority: 23.03.2004 JP 2004084149
(71) Applicant: ROHM CO., LTD., Kyoto-shi, Kyoto 615-8585 (JP)
(72) Inventor: OKI, Hirokazu, c/o ROHM CO., LTD., Kyoto-Shi Kyoto 6158585 (JP); IDE, Yuzo, c/o ROHM CO., LTD., Kyoto-Shi Kyoto 6158585 (JP)
(74) Representative: Glawe, Delfs, Moll
(86) International application number: PCT/JP2005/004446
(87) International publication number: WO 2005/091358

(57) **Abstract**

Provided is a semiconductor integrated circuit device having an output portion that outputs via a switch element a predetermined voltage to the outside from a voltage output terminal through a voltage output line and a control portion that performs predetermined control based on a control signal inputted from outside to a signal input line or a signal input terminal that is so arranged as to be adjacent to a voltage output line or a voltage output terminal. To achieve a highly-reliable semiconductor integrated circuit device that is prevented from being broken even when the voltage output terminal and a terminal adjacent thereto are short-circuited, there is provided a voltage detection portion that detects that a voltage higher than a reference voltage is inputted to the signal input line or the signal input terminal and feeds the resultant signal to the output portion as a voltage detection signal, and the output portion opens the switch element when the voltage detection signal is provided thereto.

## Description

### Technical Field

The present invention relates to

### Background Art

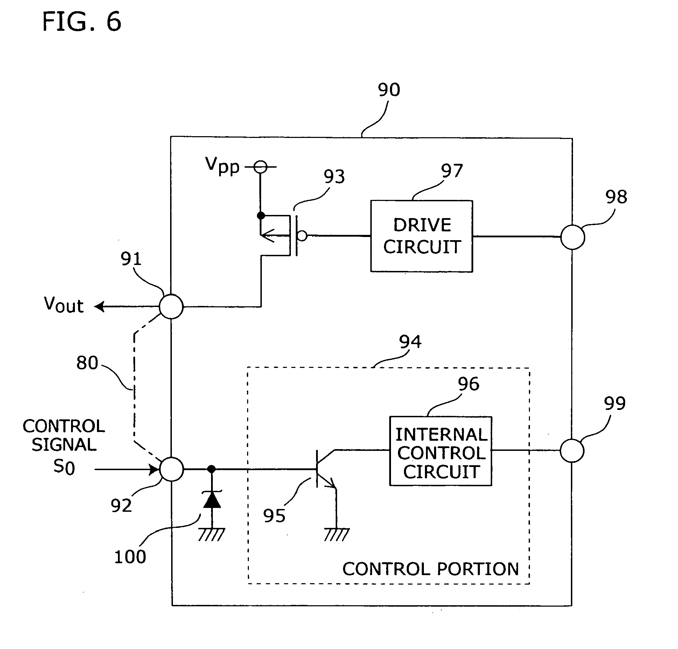

FIG. 6 is a circuit block diagram schematically showing the configuration of a conventional semiconductor integrated circuit device. In FIG. 6, reference numeral 90 represents a semiconductor integrated circuit device (hereinafter, an "IC (integrated circuit)). The IC 90 is built with a voltage output terminal 91 from which a voltage Vout is outputted, a signal input terminal 92 that receives a control signal S0, a P-channel MOS (metal oxide semiconductor) transistor 93 connected between a direct current power source Vpp (of, for example, 50 V) and the voltage output terminal 91, a drive circuit 97 that drives the MOS transistor 93 based on a signal provided from outside via a connection terminal 98, and a control portion 94 that performs predetermined control based on the control signal S0. The drain of the MOS transistor 93 is connected to the direct current power source Vpp, the source thereof is connected to the voltage output terminal 91, and the gate thereof is connected to the drive circuit 97.

The control portion 94 has an NPN transistor 95 that amplifies the control signal S0 and then gives the resultant signal to an internal control circuit 96. The base of the NPN transistor 95 is connected to the signal input terminal 92, the collector thereof is connected to the internal control circuit 96, and the emitter thereof is connected to the ground. As a result of the NPN transistor 95 being turned on/off according to an H (High)/L (Low) level of the control signal S0, the control signal S0 is transmitted to the internal control circuit 96. In response to the control signal S0 thus transmitted, the internal control circuit 96 performs predetermined control, and the resultant control output is outputted to the outside via a connection terminal 99. The breakdown voltage of the control portion 94 is set, for example, at 7 V.

When the IC 90 configured as described above is implemented on a substrate by being soldered thereto, an arrangement in which the voltage output terminal 91 and the signal input terminal 92 are arranged on the outer edge of the package of the IC 90 so as to be adjacent to each other may cause solder bridging between the voltage output terminal 91 and the signal input terminal 92. Instead, after an extended period of use, foreign matter such as dust may get stuck between the voltage output terminal 91 and the signal input terminal 92. Assume, for example, that such foreign matter possesses electrical conductivity or solder bridging occurs, that is, the voltage output terminal 91 and the signal input terminal 92 are almost short-circuited by conductive material 80 such as foreign matter or solder bridges. Then, when the MOS transistor 93 is turned on, a high voltage (for example, 50 V) is applied via the signal input terminal 92 to the control portion 94 including the NPN transistor 95. This may cause voltage breakdown of the control portion 94 built with an element having a low breakdown voltage (for example, 7 V).

To prevent the control portion 94 from being broken when a short circuit occurs, the following measures can be taken. The breakdown voltage of the control portion 94 may be made equal to or higher than the voltage of the direct current power source Vpp; instead, overvoltage protection may be provided by attaching a voltage clamping element 100 such as a Zener diode to the signal input terminal 92, and thereby clamping a voltage to be applied to the control portion 94 so as not to become equal to or higher than a predetermined voltage.

As another conventional technique, there is proposed a semiconductor integrated circuit device that, when a high voltage is detected with a step-up circuit, stops stepping up a signal voltage to be fed to the gate of an output transistor for preventing the output transistor from being broken (see, for example, Patent Document 1).
Patent Document 1: JP-A-2000-003591

### Disclosure of the Invention

### Problems to be Solved by the Invention

However, to make the breakdown voltage of the control portion 94 equal to or higher than the voltage of the direct current power source Vpp, all component elements of the control portion 94 have to be replaced with their counterparts having higher breakdown voltages. This disadvantageously increases costs. On the other hand, by attaching a voltage clamping element 100 such as a Zener diode to the signal input terminal 92, it is indeed possible to prevent the control portion 94 from being broken. However, without a current limiting function for limiting a current flowing from the MOS transistor 93 to the voltage clamping element 100 via the conductive material 80, such a current may cause a conductor or the like of a short circuit path including the MOS transistor 93 and the conductive material 80 to produce heat. This undesirably causes a breakdown of the IC 90 itself, or causes a substrate or the like on which the IC 90 is implemented to emit smoke or catch fire. In addition, the IC 90 provided with a current limiting function produces heat, though not to the extent of emitting smoke or catching fire, and thus requires unnecessary power consumption.

Moreover, with the conventional technique disclosed in Patent Document 1, the following problem arises. Although this technique can prevent an output transistor from being broken when a power source voltage exceeds a predetermined voltage, it is impossible to prevent a control circuit or the like from being broken when a high voltage outputted from the output transistor when the output terminal and a terminal adjacent thereto are almost short-circuited is applied to the control circuit or the like connected to the adjacent terminal.

In view of the conventionally experienced problems described above, it is an object of the present invention to provide a semiconductor integrated circuit device and a switching power source device using the same that output a predetermined voltage from a voltage output terminal to the outside of the device via a switch element, and to provide a highly-reliable semiconductor integrated circuit device and a switching power source device using the same that are prevented from being broken even when the voltage output terminal and a terminal adjacent thereto are short-circuited.

### Means for Solving the Problem

To achieve the above object, according to the present invention, a semiconductor integrated circuit device is provided with an input conductor that is connected from outside to an input circuit operating on a first power source voltage and an output conductor leading to the outside that is adjacent to the input conductor and is connected to an output side of a switch element operating on a second power source voltage that is higher than the first power source voltage. Here, upon detecting that a voltage higher than a reference voltage is inputted to the input conductor, an output from the output side of the switch element connected to the output conductor adjacent to the input conductor is inhibited. With this configuration, it is possible to prevent the second power source voltage from being applied to the input circuit when the input conductor and the output conductor are almost short-circuited.

According to the present invention, a semiconductor integrated circuit device is provided with an output portion that outputs a predetermined voltage to the outside from a voltage output terminal via a switch element and a control portion that can control and open the switch element when a voltage inputted to an voltage input terminal from outside is higher than a reference voltage. Here, the voltage input terminal is so arranged as to be adjacent to the voltage output terminal. With this configuration, it is possible to prevent a voltage applied to the voltage input terminal from the voltage output terminal from becoming higher than the reference voltage when the voltage output terminal and the voltage input terminal adjacent thereto are almost short-circuited.

According to the present invention, a semiconductor integrated circuit device is provided with an output portion that outputs a pulse voltage obtained by switching a direct-current voltage with a switch element to an external smoothing circuit from a voltage output terminal and a control portion that controls the switch element so that a feedback voltage based on an output voltage of the smoothing circuit becomes equal to a reference voltage, the output voltage being inputted from outside to a voltage input terminal. Here, the voltage input terminal is so arranged as to be adjacent to the voltage output terminal. With this configuration, it is possible to prevent the pulse voltage applied to the voltage input terminal from the voltage output terminal from becoming higher than the reference voltage when the voltage output terminal and the voltage input terminal adjacent thereto are almost short-circuited.

According to the present invention, a semiconductor integrated circuit device is provided with an output portion that outputs via a switch element a predetermined voltage to the outside from a voltage output terminal through a voltage output line and a control portion that performs predetermined control based on a control signal inputted from outside to a signal input line or a signal input terminal that is so arranged as to be adjacent to the voltage output line or the voltage output terminal. Here, there is provided a voltage detection portion that detects that a voltage higher than a reference voltage is inputted to the signal input line or the signal input terminal and feeds the resultant voltage to the output portion as a voltage detection signal, and the output portion opens the switch element when the voltage detection signal is provided thereto. With this configuration, it is possible to prevent a voltage applied to the signal input line or the signal input terminal from the voltage output line or the voltage output terminal from becoming higher than the reference voltage when the voltage output line or the voltage output terminal and the signal input line or the signal input terminal adjacent thereto are almost short-circuited.

Preferably, for example, the output portion may include a drive circuit that generates a driving signal for driving the switch element and a logic gate that takes the AND of the driving signal and the voltage detection signal and then feeds a resulting output to a control terminal of the switch element. With this configuration, when no voltage detection signal is provided, it is possible to close/open the switch element according to the driving signal from the drive circuit; when the voltage detection signal is provided, it is possible to open the switch element regardless of the driving signal from the drive circuit.

Preferably, for example, the voltage detection portion may include a first transistor that turns on when a voltage at the signal input terminal is higher than the reference voltage, and a second transistor that forms a current mirror circuit together with the first transistor, and the voltage detection signal may be outputted from a node at which a resistor that pulls up the second transistor and the second transistor are connected together. With this configuration, by changing the voltage at the node at which the resistor and the second transistor are connected together according to the voltage at the signal input terminal and using this voltage as the voltage detection signal, it is possible to detect that the voltage at the signal input terminal becomes higher than the reference voltage with a simple circuit configuration.

Preferably, for example, the voltage detection portion may further include a diode in a current path between the signal input terminal and the first transistor, and a value obtained by adding a forward voltage of the diode and a base-emitter voltage of the first transistor may be equivalent to the reference voltage. With this configuration, it is possible to easily form a circuit that offers a desired reference voltage.

According to the present invention, a semiconductor integrated circuit device is provided with an output portion that outputs a predetermined voltage to the outside of the device from a voltage output terminal via a switch element that is closed/opened based on an output control signal provided from an external control device, a reset input terminal that receives a reset input signal from outside, and a control portion that feeds to the external control device a reset output signal that causes the external control device to stop an output operation of the output control signal when a voltage of the reset input signal is higher than a reference voltage. Here, the reset input terminal is so arranged as to be adjacent to the voltage output terminal. With this configuration, even when the voltage output terminal and the reset input terminal adjacent thereto are almost short-circuited, by resetting the external control device to stop an output operation of the external control signal, it is possible to prevent a voltage applied to the reset input terminal from the voltage output terminal from becoming higher than the reference voltage.

For example, by setting the breakdown voltage of the switch element higher than the breakdown voltage of the control portion, it is possible to output via the switch element a voltage exceeding the breakdown voltage of elements constituting the control portion.

For example, with a switching power source device using the semiconductor integrated circuit device configured as described above, even when a voltage output terminal from which a pulse voltage resulted from a switching operation is outputted and a terminal adjacent thereto, the terminal being connected to the control portion of the semiconductor integrated circuit device, are almost short-circuited, it is possible to prevent a voltage higher than a reference voltage from being applied to the control portion.

### Effect of the Invention

According to the present invention, even when the input conductor and the output conductor adjacent to each other are almost short-circuited, the second power source voltage is not applied to the input circuit. Thus, even when the second power source voltage exceeds the breakdown voltage of the input circuit, it is possible to prevent voltage breakdown of the input circuit without increasing the breakdown voltage of the input circuit or providing overvoltage protection. This makes it possible to achieve a highly-reliable semiconductor integrated circuit device without increasing costs.

According to the present invention, even when the voltage output terminal and the voltage input terminal adjacent thereto are almost short-circuited, it is possible to prevent a voltage higher than a reference voltage from being applied to the control portion. Thus, even when the predetermined voltage exceeds the breakdown voltage of the control portion, it is possible to prevent voltage breakdown of the control portion without increasing the breakdown voltage of the control portion or providing overvoltage protection by attaching a voltage clamping element or the like to the voltage input terminal. This makes it possible to achieve a highly-reliable semiconductor integrated circuit device without increasing costs.

According to the present invention, even when the voltage output terminal and the voltage input terminal adjacent thereto are almost short-circuited, it is possible to prevent a voltage higher than a reference voltage from being applied to the control portion. Thus, even when a pulse voltage outputted from the voltage output terminal exceeds the breakdown voltage of the control portion, it is possible to prevent voltage breakdown of the control portion without increasing the breakdown voltage of the control portion or providing overvoltage protection by attaching a voltage clamping element or the like to the voltage input terminal. This makes it possible to achieve a highly-reliable semiconductor integrated circuit device without increasing costs.

According to the present invention, even when the voltage output line or the voltage output terminal and the signal input line or the signal input terminal adjacent thereto are almost short-circuited, it is possible to prevent a voltage higher than a reference voltage from being applied to the control portion. Thus, even when the predetermined voltage exceeds the breakdown voltage of the control portion, it is possible to prevent voltage breakdown of the control portion without increasing the breakdown voltage of the control portion or providing overvoltage protection by attaching a voltage clamping element or the like to the voltage input terminal. This makes it possible to achieve a highly-reliable semiconductor integrated circuit device without increasing costs.

According to the present invention, even when the voltage output terminal and the reset input terminal adjacent thereto are almost short-circuited externally, it is possible to prevent a voltage higher than a reference voltage from being applied to the control portion. Thus, even when the predetermined voltage exceeds the breakdown voltage of the control portion, it is possible to prevent voltage breakdown of the control portion without increasing the breakdown voltage of the control portion or providing overvoltage protection by attaching a voltage clamping element or the like to the reset input terminal. This makes it possible to achieve a highly-reliable semiconductor integrated circuit device without increasing costs.

According to the present invention, a switching power source device adopts the semiconductor integrated circuit device configured as described above. Thus, even when a voltage output terminal from which a pulse voltage resulted from a switching operation is outputted and a terminal connected to the control portion of the semiconductor integrated circuit device are almost short-circuited, it is possible to prevent a voltage higher than a reference voltage from being applied to the control portion. This makes it possible to achieve a highly-reliable switching power source device in which the control portion is prevented from voltage breakdown.

### Brief Description of Drawings

[Fig. 1] A circuit block diagram showing the configuration of a semiconductor integrated circuit device of a first embodiment of the present invention.
[FIG. 2] A circuit block diagram showing the configuration of a regulator IC of a second embodiment of the present invention.
[FIG. 3] A circuit block diagram showing the configuration of a semiconductor integrated circuit device of a third embodiment of the present invention.
[FIG. 4] A circuit diagram showing a practical example of the circuit blocks provided in the voltage detection portion shown in FIG. 3.
[FIG. 5] A circuit block diagram showing the configuration of a semiconductor integrated circuit device of a fourth embodiment of the present invention.
[FIG. 6] A circuit block diagram showing the configuration of a conventional semiconductor integrated circuit device.

### List of Reference Symbols

- 1, 10, 60: IC (semiconductor integrated circuit device)
- 2, 12, 62: voltage output terminal
- 2a, 12a, 62a: output conductor
- 3: voltage input terminal
- 3a, 13a, 63a: input conductor
- 4, 14, 40, 64: output portion
- 5, 15, 41, 65: MOS transistor (switch element)
- 6, 16, 42, 66: drive circuit
- 7, 17, 50, 67: control portion (input circuit)
- 8, 18, 68: comparator
- 9, 19,51,69: reference voltage source
- 11, 29, 39, 59, 61: power source terminal
- 13, 24, 73: signal input terminal
- 21: NAND gate (logic gate)
- 22: voltage detection portion
- 23: current mirror circuit
- 25: NPN transistor
- 26, 74: internal control circuit
- 27, 28: connection terminal
- 30: switching power source device
- 31: regulator IC (semiconductor integrated circuit device)
- 32: IN terminal
- 33: SW terminal (voltage output terminal)
- 34: INV terminal (voltage input terminal)
- 35: FB terminal
- 36: GND terminal
- 37: smoothing circuit
- 38: phase lag compensation circuit
- 52: error amplifier
- 53: PWM comparator
- 54: oscillation circuit
- 63: reset input terminal
- 70: output control terminal
- 71: reset output terminal
- 72: microcomputer (external control device)
- C 1: smoothing capacitor
- C2, C3, C4: capacitor
- D1, D11, D12: diode
- L1: coil
- R1, R2, R3, R1: I voltage dividing resistor
- Q1, Q2 NPN: transistor
- Vcc: internal control power source
- Vdd: direct current power source (first power source voltage)
- Vpp: direct current power source (second power source voltage)
- Vref: reference voltage

### Best Mode for Carrying Out the Invention

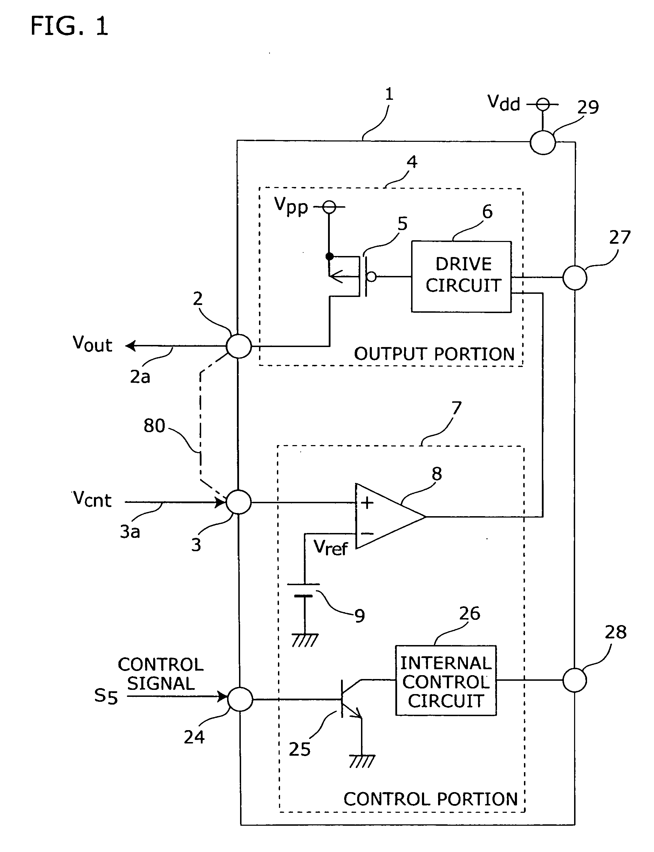

Hereinafter, embodiments of the present invention will be described with reference to the accompanying drawings. FIG. 1 is a circuit block diagram schematically showing the configuration of an IC of a first embodiment of the present invention. In FIG. 1, reference numeral 1 represents an IC. The IC 1 is built with an output portion 4 that outputs a voltage Vout from a voltage output terminal 2 to the outside via an external output conductor 2a and a control portion 7 that controls the output portion 4 based on an external input or an output control voltage Vcnt externally fed from an external input conductor 3a via a voltage input terminal 3, and performs predetermined control based on a control signal S5 provided via a signal input terminal 24.

The relevant parts of the IC 1 operate on a direct current power source Vdd (of, for example, 5 V) fed thereto via a power source terminal 29. The voltage output terminal 2 and the voltage input terminal 3 are arranged on the outer edge of the package of the IC 1 so as to be adjacent to each other, or the output conductor 2a and the input conductor 3a are arranged so as to be adjacent to each other somewhere along the line.

The output portion 4 has a P-channel MOS transistor 5 connected between a direct current power source Vpp (of, for example, 50 V) having a higher voltage than that of the direct current power source Vdd and the voltage output terminal 2, and a drive circuit 6 that drives the MOS transistor 5 based on a signal externally provided via a connection terminal 27. The drain of the MOS transistor 5 is connected to the direct current power source Vpp, the source thereof is connected to the voltage output terminal 2, and the gate thereof is connected to the drive circuit 6.

The control portion 7 has an NPN transistor 25 that amplifies the control signal S5 and then provides it to an internal control circuit 26. The base of the NPN transistor 25 is connected to the signal input terminal 24, the collector thereof is connected to the internal control circuit 26, and the emitter thereof is connected to the ground. As a result of the NPN transistor 25 being turned on/off according to an H/L level of the control signal S5, the control signal S5 is transmitted to the internal control circuit 26. In response to the control signal thus transmitted, the internal control circuit 26 performs predetermined control, and a control output thereof is outputted to the outside via a connection terminal 28.

The control portion 7 also has a comparator 8 and a reference voltage source 9. The non-inverting input terminal (+) of the comparator 8 is connected to the voltage input terminal 3, and the inverting input terminal (-) thereof is connected to the reference voltage source 9. The output terminal of the comparator 8 is connected to the input terminal of the drive circuit 6. The comparator 8 compares the output control voltage Vcnt fed to the non-inverting input terminal (+) thereof with a reference voltage Vref (for example, 2 V) fed to the inverting input terminal (-) thereof. In a case where the output control voltage Vcnt is higher than the reference voltage Vref, the comparator 8 outputs an H level; in a case where the output control voltage Vcnt is lower than the reference voltage Vref, it outputs an L level. The breakdown voltage of the control portion 7 is set, for example, at 7 V. Although in FIG. 1 the input conductor 3a is connected to the voltage input terminal 3, the input conductor 3a does not necessarily have to be provided. In normal use, the voltage input terminal 3 simply has to be fed with an input voltage at which the comparator 8 outputs an L level.

The drive circuit 6 buffers an output of the comparator 8, and then outputs it to the gate of the MOS transistor 5 to drive the MOS transistor 5. That is, in a case where the output of the comparator 8 is at H level, the MOS transistor 5 is turned off; in a case where the output of the comparator 8 is at L level, the MOS transistor 5 is turned on. At this point, when the MOS transistor 5 is on, the voltage Vout outputted from the voltage output terminal 2 becomes approximately equal to the voltage of the direct current power source Vpp (about 50 V); when the MOS transistor 5 is off, it becomes 0 V.

In the IC 1 configured as described above, to deal with the problem similar to the aforementioned conventional example, the voltage input terminal 3 or the input conductor 3a is provided between the voltage output terminal 2 and the signal input terminal 24. This makes the voltage output terminal 2 and the signal input terminal 24 or the output conductor 2a and an input conductor for the control signal S5 less likely to be short-circuited by conductive material 80 such as foreign matter or solder bridges. If the voltage output terminal 2 and the voltage input terminal 3 are short-circuited, or the output conductor 2a and the input conductor 3a are almost short-circuited somewhere along the line, a voltage Vout is applied to the control portion 7 via the voltage input terminal 3. However, in that case, the voltage at the voltage input terminal 3, i.e. the voltage at the non-inverting input terminal (+) of the comparator 8 becomes higher than the reference voltage Vref, and the comparator 8 outputs an H level to turn off the MOS transistor 5. This prevents the voltage Vout applied to the voltage input terminal 3 from exceeding the reference voltage Vref.

Thus, even when a short circuit occurs, voltage breakdown of the control portion 7 is prevented. Moreover, even when a short circuit occurs, as a result of the MOS transistor 5 being turned off, a high current does not flow through the conductive material 80 or an element or conductor of a short-circuit path. This eliminates the possibility that the conductive material 80 or an element or conductor of a short-circuit path produces heat and thus causes a substrate or the like on which the IC 1 is implemented to emit smoke or catch fire, or causes unnecessary power consumption.

As described above, despite an increase in the number of terminals, arranging the voltage input terminal 3 so as to be adjacent to the voltage output terminal 2 makes the voltage output terminal 2 and the signal input terminal 24 less likely to be short-circuited because of an increased distance between them. In addition, even when the voltage output terminal 2 and a terminal adjacent thereto are almost short-circuited, such an arrangement can prevent voltage breakdown of the IC 1 including the control portion 7 without increasing the breakdown voltage of the control portion 7 connected to the adjacent terminal or providing overvoltage protection by attaching a voltage clamping element or the like to the adjacent terminal, and thus contributes to higher reliability of the IC 1.

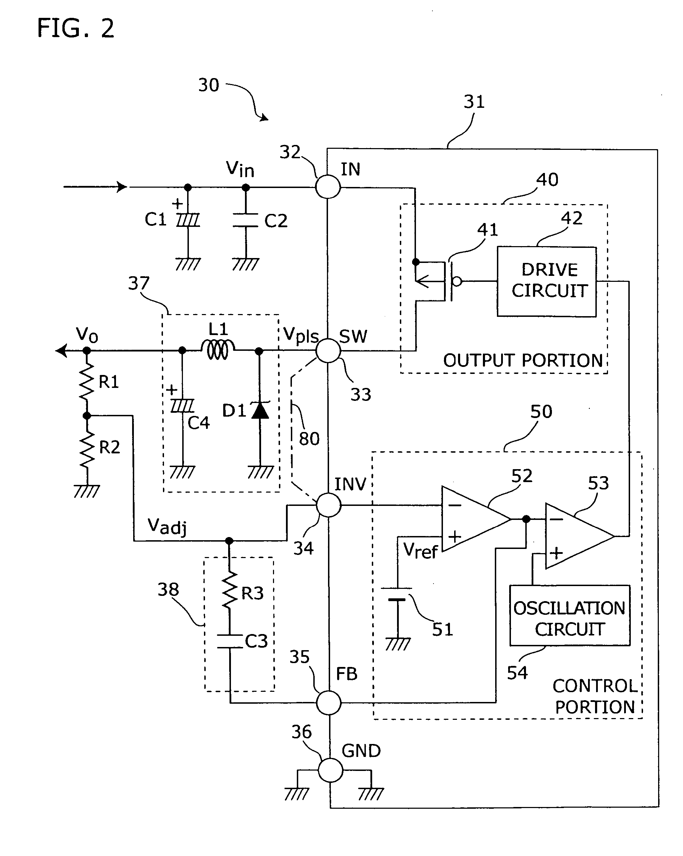

FIG. 2 is a circuit block diagram showing the configuration of a switching power source device adopting an IC of a second embodiment of the present invention. In FIG. 2, reference numeral 30 represents a switching power source device. The switching power source device 30 is built with a regulator IC 31 integrated on one chip and a large number of external elements that are externally connected to the regulator IC 31.

The regulator IC 31 is built with five terminals for connection to external elements, an output portion 40, and a control portion 50. The output portion 40 is built with a P-channel MOS transistor 41 and a drive circuit 42 that drives the MOS transistor 41, and the control portion 50 is built with a reference voltage source 51, an error amplifier 52, a PWM comparator 53, and an oscillation circuit 54.

An IN terminal 32 is fed with an input voltage Vin (for example, 50 V), and, between the IN terminal 32 and the ground, a smoothing capacitor C1 and a noise removal capacitor C2 are externally connected in parallel. A pulse voltage Vpls obtained by switching the input voltage Vin with the MOS transistor 41 is outputted from an SW terminal 33, to which a smoothing circuit 37 is externally connected. This smoothing circuit 37 is built with a coil L1, a diode (for example, a Schottky barrier diode) D1, and a smoothing capacitor (for example, an electrolytic capacitor) C4. The cathode of the diode D1 and one end of the coil L1 are connected to the SW terminal 33, the other end of the coil L1 is connected to one end of the smoothing capacitor C4, and the other end of the smoothing capacitor C4 and the anode of the diode D1 are connected to the ground.

The other end of the coil L1 is connected to the ground via a circuit in which voltage dividing resistors R1 and R2 are connected in series, and a node at which the voltage dividing resistors R1 and R2 are connected together is connected to an INV terminal 34. The INV terminal 34 is connected to the inverting input terminal (-) of the error amplifier 52 inside the regulator IC 31. The non-inverting input terminal (+) of the error amplifier 52 is connected to the reference voltage source 51, and the output terminal of the error amplifier 52 is connected to the inverting input terminal (-) of the PWM comparator 53 and an FB terminal 35. Between the FB terminal 35 and the INV terminal 34, a phase lag compensation circuit 38 built as a circuit in which a capacitor C3 and a resistor R3 are connected in series is externally connected.

The non-inverting input terminal (+) of the PWM comparator 53 is connected to the output terminal of the oscillation circuit 54, and the output terminal of the PWM comparator 53 is connected to the input terminal of the drive circuit 42. The output terminal of the drive circuit 42 is connected to the gate of the MOS transistor 41, the source of the MOS transistor 41 is connected to the IN terminal 32, and the drain thereof is connected to the SW terminal 33. A GND terminal 36 is connected to the ground to determine a reference potential of the regulator IC 31. The relevant parts of the IC 31 operate on a direct-current voltage (for example 5 V) that is derived from the input voltage Vin and is lower than the input voltage Vin. The breakdown voltage of the control portion 50 is set, for example, at 7 V.

Next, how the relevant parts of the switching power source device 30 operate will be described. The input voltage Vin is converted into a pulse voltage Vpls by a switching operation of the MOS transistor 41. When the MOS transistor 41 is on, a current flows from the IN terminal 32 to the coil L1 via the MOS transistor 41. As a result, energy is stored in the coil L1 and the smoothing capacitor C4 is charged. On the other hand, when the MOS transistor 41 is off, the energy stored in the coil L1 is circulated by the diode D1 and the smoothing capacitor C4 is charged. Then, a voltage outputted from the smoothing capacitor C4 is fed to the outside as an output voltage Vo.

The output voltage Vo is divided by the voltage dividing resistors R1 and R2, and the resultant feedback voltage Vadj is inputted to the inverting input terminal (-) of the error amplifier 52 via the INV terminal 34. Then, the error amplifier 52 outputs an error signal based on the voltage difference between the reference voltage Vref (for example, 2V) inputted to the non-inverting input terminal (+) thereof and the feedback voltage Vadj inputted to the inverting input terminal (-) thereof. This reference voltage Vref is set equal to a feedback voltage Vadj obtained by dividing a predetermined output voltage Vo by the voltage dividing resistors R1 and R2.

The error signal outputted from the error amplifier 52 is inputted to the inverting input terminal (-) of the PWM comparator 53. The non-inverting input terminal (+) of the PWM comparator 53 is fed with a triangular wave having a predetermined frequency from the oscillation circuit 54. The PWM comparator 53 compares the voltage at the inverting input terminal (-) thereof with the voltage at the non-inverting input terminal (+) thereof. When the voltage at the non-inverting input terminal (+) becomes higher than the voltage at the inverting input terminal (-), the PWM comparator 53 outputs an H (High) level PWM signal to the drive circuit 42; when the voltage at the inverting input terminal (-) becomes higher than the voltage at the non-inverting input terminal (+), the PWM comparator 53 outputs an L (Low) level PWM signal to the drive circuit 42.

The drive circuit 42 outputs an output signal obtained by buffering the PWM signal from the PWM comparator 53 to the gate of the MOS transistor 41, thereby driving the MOS transistor 41. Specifically, when the PWM signal is at H level, the MOS transistor 41 is turned off; when the PWM signal is at L level, the MOS transistor 41 is turned on. Thus, the drive circuit 42 outputs a pulse signal having the same frequency as the oscillating frequency of the oscillation circuit 54, and the duty cycle of the pulse signal is determined based on the error signal from the error amplifier 52. That is, the duty cycle is controlled as follows. The higher the output voltage Vo is above a predetermined voltage, the longer the duration of H level of the PWM signal, i.e. the duration for which the MOS transistor 41 is off; the lower the output voltage Vo is below the predetermined voltage, the longer the duration of L level of the PWM signal, i.e. the duration for which the MOS transistor 41 is on.

For a smaller and lighter switching power source device 30, a switching frequency has to be set at a higher frequency by setting the oscillating frequency of the oscillation circuit 54 at a higher frequency. This requires the control elements and the like in the control portion 50 to have good frequency characteristics. However, if an error amplifier 52 having a good frequency characteristic is used, the circuitry may suffer from oscillation. To deal with this problem, the phase lag compensation circuit 38 built as a circuit in which the capacitor C3 and the resistor R3 are connected in series is externally connected between the FB terminal 35 and the INV terminal 34, whereby it is possible to prevent the oscillation of the circuitry even when a switching frequency is set at a higher frequency by using an error amplifier 52 having a good frequency characteristic.

As described above, since the duty cycle of the PWM signal is adjusted as a result of a feedback operation being performed in such a way that the feedback voltage Vadj becomes equal to the reference voltage Vref, the output voltage Vo is in general stably maintained at a predetermined voltage. Assume that in this circuit the INV terminal 34 is arranged so as to be adjacent to the SW terminal 33 from which a pulse voltage Vpls is outputted. Then, for causes similar to those discussed above regarding the conventional example, in this switching power source device 30, the SW terminal 33 and the INV terminal 34 may be almost short-circuited by conductive material 80 such as foreign matter or solder bridges. In that case, however, the pulse voltage Vpls is applied to the INV terminal 34, and the duty cycle of the MOS transistor 41 is immediately adjusted so that the voltage at the INV terminal 34, i.e. the voltage at the inverting input terminal (-) of the error amplifier 52 becomes equal to the reference voltage Vref. As a result, the pulse voltage Vpls applied to the INV terminal 34 is decreased and thus prevented from exceeding the reference voltage Vref.

Thus, even when a short circuit occurs, voltage breakdown of the control portion 50 is prevented. Moreover, even when a short circuit occurs, a high current does not flow through the conductive material 80 or an element or conductor of a short-circuit path. This eliminates the possibility that the conductive material 80 or an element or conductor of a short-circuit path produces heat and thus causes a substrate or the like on which the IC 31 is implemented to emit smoke or catch fire, or causes unnecessary power consumption.

As described above, arranging the INV terminal 34 so as to be adjacent to the SW terminal 33 makes it possible, even when the SW terminal 33 and the INV terminal adjacent thereto are almost short-circuited, to prevent voltage breakdown of the regulator IC 31 including the control portion 50 without increasing the breakdown voltage of the control portion 50 connected to the adjacent INV terminal or providing overvoltage protection by attaching a voltage clamping element or the like to the INV terminal, and thus contributes to higher reliability of the regulator IC 31 and the switching power source device 30.

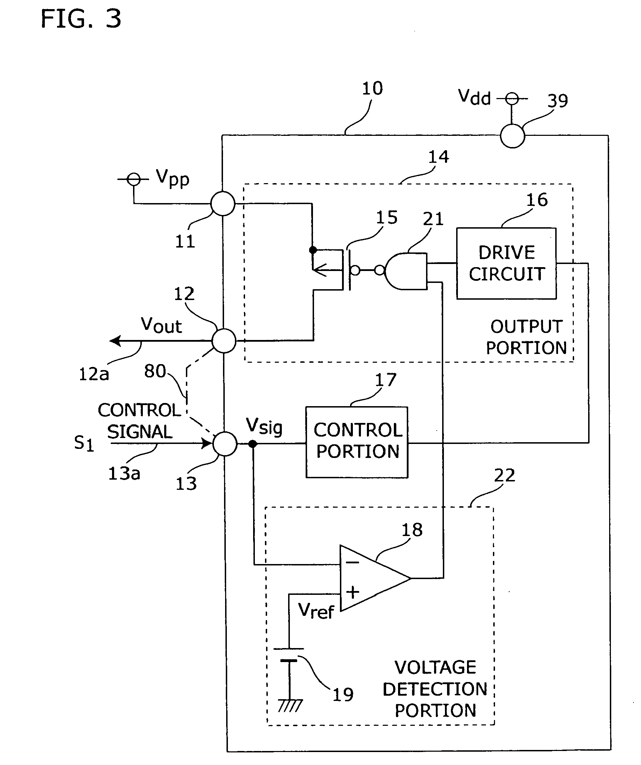

FIG. 3 is a circuit block diagram schematically showing the configuration of an IC of a third embodiment of the present invention. In FIG. 3, reference numeral 10 represents an IC. The IC 10 is built with a power source terminal 39 connected to a direct current power source Vdd (of, for example, 5 V) on which the relevant parts of the IC 10 operate, a power source terminal 11 connected to another direct current power source Vpp (of, for example, 50 V) having a higher voltage than that of the direct current power source Vdd, a voltage output terminal 12 from which a voltage Vout is outputted via an external output conductor 12a, a signal input terminal 13 that receives a control signal S1 via an external input conductor 13a, an output portion 14 provided between the power source terminal 11 and the voltage output terminal 12, a control portion 17 that performs predetermined control for carrying out a function of the IC 10 based on the control signal S 1 and controls a drive circuit 16, and a voltage detection portion 22. The voltage output terminal 12 and the signal input terminal 13 are arranged on the outer edge of the package of the IC 10 so as to be adjacent to each other, or the output conductor 12a and the input conductor 13a are arranged so as to be adjacent to each other somewhere along the line. The breakdown voltage of the control portion 17 is set, for example, at 7 V.

The output portion 14 is built with a P-channel MOS transistor 15, a drive circuit 16 that generates a driving signal for driving the MOS transistor 15, and a NAND gate 21. The drain of the MOS transistor 15 is connected to the power source terminal 11, the source thereof is connected to the voltage output terminal 12, and the gate thereof is connected to the output terminal of the NAND gate 21. One input terminal of the NAND gate 21 is connected to the drive circuit 16, and the other input terminal thereof is connected to the output terminal of a comparator 18 provided in the voltage detection portion 22.

The voltage detection portion 22 has a comparator 18 and a reference voltage source 19. The inverting input terminal (-) of the comparator 18 is connected to the signal input terminal 13, and the non-inverting input terminal (+) thereof is connected to the reference voltage source 19. The output terminal of the comparator 18 is connected to the other input terminal of the NAND gate 21. The comparator 18 compares a voltage Vsig fed to the inverting input terminal (-) thereof from the signal input terminal 13 with a reference voltage Vref (for example, 2 V) fed to the non-inverting input terminal (+) thereof. When the voltage Vsig is higher than the reference voltage Vref, the comparator 18 outputs an L level; when the voltage Vsig is lower than the reference voltage Vref, the comparator 18 outputs an H level. The L level outputted when the voltage Vsig is higher than the reference voltage Vref is fed to the NAND gate 21 as a voltage detection signal.

The NAND gate 21 takes the AND of the output of the comparator 18 and the driving signal fed from the drive circuit 16, then inverts the result therein, and then outputs the resulting signal to the gate of the MOS transistor 15 to drive the MOS transistor 15. That is, in a case where the output of the comparator 18 is at H level, the NAND gate 21 turns on/off the MOS transistor 15 by outputting an output signal according to the voltage level of the driving signal from the drive circuit 16. On the other hand, in a case where the output of the comparator 18 is at L level, the NAND gate 21 turns off the MOS transistor 15 by outputting an H level signal regardless of voltage level of the driving signal from the drive circuit 16. At this point, when the MOS transistor 15 is on, the voltage Vout outputted from the voltage output terminal 12 becomes approximately equal to the voltage of the direct current power source Vpp (about 50 V); when the MOS transistor 15 is off, it becomes 0 V.

The IC 10 configured as described above normally operates so as to turn on/off the MOS transistor 15 according to the output of the control portion 17. On the other hand, as in the case of the aforementioned conventional example, if the voltage output terminal 12 and the signal input terminal 13 are almost short-circuited by conductive material 80 such as foreign matter or solder bridges, or the output conductor 12a and the input conductor 13a are almost short-circuited somewhere along the line, the voltage Vout is applied to the control portion 17 via the signal input terminal 13. At this point, when the voltage Vsig at the signal input terminal 13, i.e. the voltage at the inverting input terminal (-) of the comparator 18 becomes higher than the reference voltage Vref, the comparator 18 outputs an L level to turn off the MOS transistor 15. This prevents the voltage Vout applied to the signal input terminal 13 from exceeding the reference voltage Vref.

By doing this, there is no need to increase the breakdown voltage of the control portion 17 or to provide overvoltage protection by attaching a voltage clamping element or the like to the signal input terminal 13. Even when the voltage output terminal 12 from which a voltage exceeding the breakdown voltage of the control portion 17 is outputted and the signal input terminal 13 adjacent thereto are almost short-circuited, it is possible to prevent voltage breakdown of the control portion 17, and thereby achieve higher reliability of the IC 10. Moreover, even when such a short circuit occurs, a high current does not flow through the conductive material 80 or an element or conductor of a short-circuit path. This eliminates the possibility that the conductive material 80 or an element or conductor of a short-circuit path produces heat and thus causes a substrate or the like on which the IC 10 is implemented to emit smoke or catch fire, or causes unnecessary power consumption.

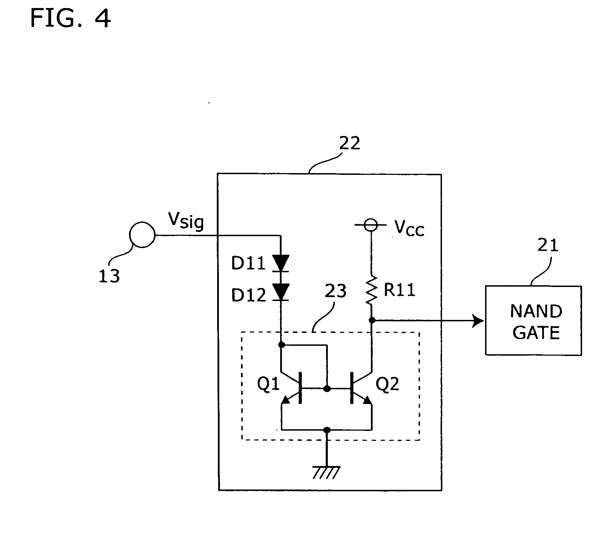

Incidentally, the voltage detection portion 22 shown in FIG. 3 can be built as a circuit shown in FIG. 4. FIG. 4 is a circuit diagram showing a practical example of the circuit blocks provided in the voltage detection portion 22. In FIG. 4, such circuit blocks as are found also in FIG. 3 are identified with the same reference numerals, and their explanations will not be repeated. The voltage detection portion 22 shown in FIG. 4 is built with diodes D11 and D12, a current mirror circuit 23, an internal control power source Vcc, and a resistor R11.

The current mirror circuit 23 is built with a pair of NPN transistors Q1 and Q2 whose bases are connected together and whose emitters are connected to the ground. The collector of the NPN transistor Q1 is connected to the base thereof and to the cathode of the diode D12. The anode of the diode D12 is connected to the cathode of the diode D11, and the anode of the diode D11 is connected to the signal input terminal 13.

The collector of the NPN transistor Q2 is connected to the internal control power source Vcc via the resistor R11. A voltage at a node at which the resistor R11 and the NPN transistor Q2 are connected together, that is, a collector voltage of the NPN transistor Q2 is fed to an input terminal of the NAND gate 21. The internal control power source Vcc is a direct current power source that feeds a voltage that is sufficient to drive the logic gate.

Next, operation of the voltage detection portion 22 configured as described above will be described. When a voltage Vsig at the signal input terminal 13 becomes higher than the voltage (for example, 2 V) obtained by adding the forward voltage of the diodes D11 and D12 and the base-emitter voltage of the NPN transistor Q1, the NPN transistor Q1 is turned on, and a predetermined collector current flows thorough the NPN transistor Q1. This collector current is mirrored to the NPN transistor Q2, whereby as much collector current as the one flowing through the NPN transistor Q1 flows through the NPN transistor Q2. At this point, the collector voltage of the NPN transistor Q2 is equal to the ground level, i.e. the voltage at L level.

On the other hand, when a voltage Vsig is lower than the voltage obtained by adding the forward voltage of the diodes D 1 and D12 and the base-emitter voltage of the NPN transistor Q1, the NPN transistor Q1 is turned off, and the NPN transistor Q2 is also turned off. At this point, the collector voltage of the NPN transistor Q2 is equal to the voltage of the internal control power source Vcc, i.e. the voltage at H level.

As described above, since the collector voltage of the NPN transistor Q2 is changed according to the voltage Vsig at the signal input terminal 13, by using this voltage as a voltage detection signal, it is possible to detect that the voltage Vsig at the signal input terminal 13 becomes higher than the reference voltage (in this embodiment, 2 V) with a simple circuit configuration.

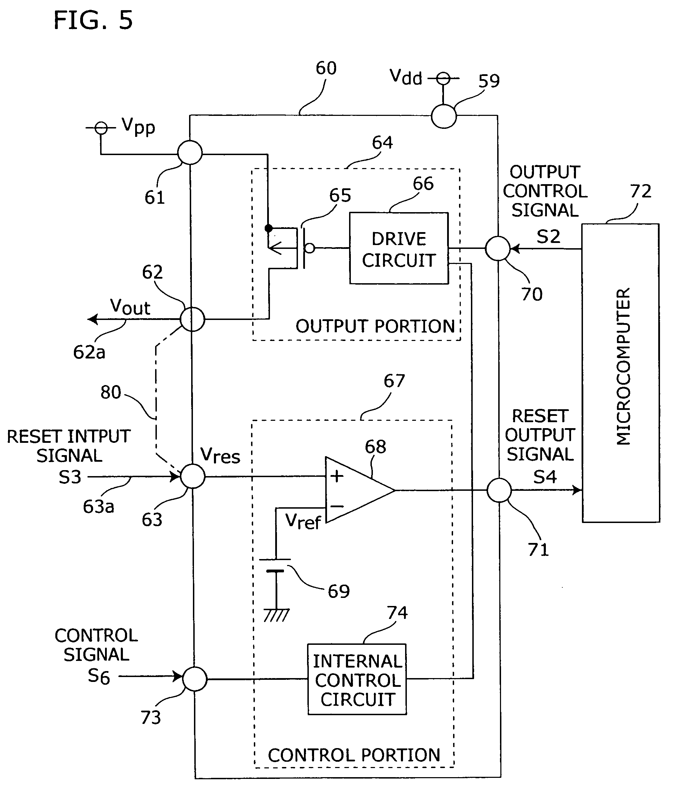

FIG. 5 is a circuit block diagram schematically showing the configuration of an IC of a fourth embodiment of the present invention. In FIG. 5, reference numeral 60 represents an IC. The IC 60 includes a power source terminal 59 connected to a direct current power source Vdd (of, for example, 5 V) on which the relevant parts of the IC 60 operate, a power source terminal 61 connected to another direct current power source Vpp (of, for example, 50 V) having a higher voltage than that of the direct current power source Vdd, a voltage output terminal 62 from which a voltage Vout is outputted via an external output conductor 62a, an output portion 64 provided between the power source terminal 61 and the voltage output terminal 62, and an output control terminal 70 that receives an output control signal S2 from an external microcomputer 72.

The output portion 64 is built with a P-channel MOS transistor 65 and a drive circuit 66 that drives the MOS transistor 65. The drain of the MOS transistor 65 is connected to the power source terminal 61, the source thereof is connected to the voltage output terminal 62, and the gate thereof is connected to the output terminal of the drive circuit 66. The input terminal of the drive circuit 66 is connected to the output control terminal 70.

The drive circuit 66 buffers an output control signal S2 provided from the microcomputer 72 via the output control terminal 70, and then outputs it to the gate of the MOS transistor 65 to drive the MOS transistor 65. That is, in a case where the output control signal S2 is at H level, the MOS transistor 65 is turned off; in a case where the output control signal S2 is at L level, the MOS transistor 65 is turned on. At this point, when the MOS transistor 65 is on, the voltage Vout outputted from the voltage output terminal 62 becomes approximately equal to the voltage of the direct current power source Vpp (about 50 V); when the MOS transistor 65 is off, it becomes 0 V.

The IC 60 further includes a reset input terminal 63 that receives a reset input signal S3 via an external input conductor 63a, a control portion 67 that generates a reset output signal S4 upon receiving a reset input signal S3 and controls the drive circuit 66 based on a control signal S6 provided thereto via a signal input terminal 73, and a reset output terminal 71 that outputs a reset output signal S4 to the microcomputer 72. The reset input terminal 63 is arranged on the outer edge of the package of the IC 60 so as to be adjacent to the voltage output terminal 62, or the output conductor 62a and the input conductor 63a are arranged so as to be adjacent to each other somewhere along the line. The breakdown voltage of the control portion 67 is set, for example, at 7 V.

The control portion 67 has an internal control circuit 74 connected to the signal input terminal 73. The internal control circuit 74 controls on/off of the MOS transistor 65 by feeding, to the drive circuit 66, an H/L level signal according to the control signal S6. The control portion 67 also has a comparator 68 and a reference voltage source 69. The non-inverting input terminal (+) of the comparator 68 is connected to the reset input terminal 63, and the inverting input terminal (-) thereof is connected to the reference voltage source 69. The output terminal of the comparator 68 is connected to the reset output terminal 71. The comparator 68 compares a voltage Vres of the reset input signal S3 provided to the non-inverting input terminal (+) thereof with a reference voltage Vref (for example, 2 V) fed to the inverting input terminal (-) thereof. In a case where the voltage Vres is higher than the reference voltage Vref, the comparator 68 outputs an H level; in a case where the voltage Vres is lower than the reference voltage Vref, the comparator 68 outputs an L level.

When the voltage Vres of the reset input signal S3 is higher than the reference voltage Vref, an H level output of the comparator 68 is fed to the microcomputer 72 as a reset output signal S4 via the reset output terminal 71. Upon receiving the reset output signal S4, the microcomputer 72 performs a reset operation and stops an output operation of the output control signal S2. In this way, by resetting the microcomputer 72 by checking the voltage of the reset input signal S3 with the comparator 68, the microcomputer 72 is prevented from being accidentally reset when a voltage such as noise is applied to the reset input terminal 63. In addition, since the reset input terminal 63 is so arranged as to be adjacent to the voltage output terminal 62, when the voltage output terminal 62 and the terminal adjacent thereto are accidentally short-circuited, the microcomputer 72 is readily reset by the voltage of the voltage output terminal 62, and thereby turning off the MOS transistor 65. In this way, it is possible to prevent a continuation of an abnormal state.

In other words, with this configuration, as in the case of the aforementioned conventional example, if the voltage output terminal 62 and the reset input terminal 63 are almost short-circuited by conductive material 80 such as foreign matter or solder bridges, or the output conductor 62a and the input conductor 63a are almost short-circuited somewhere along the line, the voltage Vout is applied to the control portion 67 via the reset input terminal 63, and the voltage at the reset input terminal 63, i.e. the voltage at the non-inverting input terminal (+) of the comparator 68 becomes higher than the reference voltage Vref. Then, the comparator 68 outputs an H level, thereby resetting the microcomputer 72. As a result, the output of the output control signal S2 is stopped, and the MOS transistor 65 is turned off. This prevents the voltage Vout applied to the reset input terminal 63 from exceeding the reference voltage Vref.

Thus, even when a short circuit occurs, voltage breakdown of the control portion 67 is prevented. Moreover, even when a short circuit occurs, a high current does not flow through the conductive material 80 or an element or conductor of a short-circuit path. This eliminates the possibility that the conductive material 80 or an element or conductor of a short-circuit path produces heat and thus causes a substrate or the like on which the IC 60 is implemented to emit smoke or catch fire, or causes unnecessary power consumption.

As described above, arranging the reset input terminal 63 so as to be adjacent to the voltage output terminal 62 eliminates the need, even when the voltage output terminal 62 and the terminal adjacent thereto are almost short-circuited, to increase the breakdown voltage of the control portion 67 connected to the adjacent terminal, or to provide overvoltage protection by attaching a voltage clamping element or the like to the adjacent terminal. Such an arrangement can prevent voltage breakdown of the IC 60 including the control portion 67, and thus contributes to higher reliability of the IC 60.

It is to be understood that the present invention is not limited in any way by the embodiments thereof described above, but may be practiced in any other manner than specifically described above as embodiments, and various modifications are possible within the scope of the invention. For example, the embodiments described above deal with cases where a P-channel MOS transistor is used as a switch element that turns on/off the supply of voltage from a direct current power source. However, it is also possible to use instead an N-channel MOS transistor or a bipolar transistor. Although all the embodiments described above deal with cases in which an output MOS transistor is provided inside an IC, the output MOS transistor may be provided separately, and the output terminal thereof may be so arranged as to be adjacent to an input terminal that is connected to the control input of the output MOS transistor and fed with an input signal for turning off the output MOS transistor. Alternatively, a comparator may be given hysteresis or may be made to behave as a logical circuit so that the output transistor is prevented from being turned on once it is turned off until the power is restored thereto.

### Industrial Applicability

As described above, according to the present invention, in a semiconductor integrated circuit device that outputs a predetermined voltage via a voltage output terminal and a switching power source device using the same, even when the voltage output terminal and a terminal that is adjacent thereto and connected to a control portion are almost short-circuited externally, a voltage higher than a reference voltage is prevented from being applied to the control portion, and thereby preventing voltage breakdown of the control portion. This makes it possible to achieve higher reliability of the semiconductor integrated circuit device and the switching power source device using the same without increasing costs. Such a highly-reliable semiconductor integrated circuit device and a switching power source device using the same find useful application in in-vehicle electronic devices that require a high degree of reliability.

## Claims

1. A semiconductor integrated circuit device comprising:
an input conductor that is connected from outside to an input circuit operating on a first power source voltage; and
an output conductor leading to an outside that is adjacent to the input conductor and is connected to an output side of a switch element operating on a second power source voltage that is higher than the first power source voltage,
wherein, upon detecting that a voltage higher than a reference voltage is inputted to the input conductor, an output from the output side of the switch element connected to the output conductor adjacent to the input conductor is inhibited.

2. A semiconductor integrated circuit device comprising:
an output portion that outputs a predetermined voltage to an outside from a voltage output terminal via a switch element; and
a control portion that can control and open the switch element when a voltage inputted to an voltage input terminal from outside is higher than a reference voltage,
wherein the voltage input terminal is so arranged as to be adjacent to the voltage output terminal.

3. A semiconductor integrated circuit device comprising:
an output portion that outputs a pulse voltage obtained by switching a direct-current voltage with a switch element to an external smoothing circuit from a voltage output terminal; and
a control portion that controls the switch element so that a feedback voltage based on an output voltage of the smoothing circuit becomes equal to a reference voltage, the output voltage being inputted from outside to a voltage input terminal,
wherein the voltage input terminal is so arranged as to be adjacent to the voltage output terminal.

4. A semiconductor integrated circuit device comprising:
an output portion that outputs via a switch element a predetermined voltage to an outside from a voltage output terminal through a voltage output line; and
a control portion that performs predetermined control based on a control signal inputted from outside to a signal input line or a signal input terminal that is so arranged as to be adjacent to the voltage output line or the voltage output terminal,
wherein there is provided a voltage detection portion that detects that a voltage higher than a reference voltage is inputted to the signal input line or the signal input terminal and feeds a resultant voltage to the output portion as a voltage detection signal, and
wherein the output portion opens the switch element when the voltage detection signal is provided thereto.

5. The semiconductor integrated circuit device of claim 4,
wherein the output portion includes
a drive circuit that generates a driving signal for driving the switch element,
and
a logic gate that takes an AND of the driving signal and the voltage detection signal and then feeds a resulting output to a control terminal of the switch element.

6. The semiconductor integrated circuit device of claim 4,
wherein the voltage detection portion includes
a first transistor that turns on when a voltage at the signal input terminal is higher than the reference voltage, and
a second transistor that forms a current mirror circuit together with the first transistor, and
wherein the voltage detection signal is outputted from a node at which a resistor that pulls up the second transistor and the second transistor are connected together.

7. The semiconductor integrated circuit device of claim 6,
wherein the voltage detection portion further includes a diode in a current path between the signal input terminal and the first transistor, and
wherein a value obtained by adding a forward voltage of the diode and a base-emitter voltage of the first transistor is equivalent to the reference voltage.

8. A semiconductor integrated circuit device comprising:
an output portion that outputs a predetermined voltage to an outside of the device from a voltage output terminal via a switch element that is closed/opened based on an output control signal provided from an external control device;
a reset input terminal that receives a reset input signal from outside; and
a control portion that feeds to the external control device a reset output signal that causes the external control device to stop an output operation of the output control signal when a voltage of the reset input signal is higher than a reference voltage,
wherein the reset input terminal is so arranged as to be adjacent to the voltage output terminal.

9. The semiconductor integrated circuit device of one of claims 1 to 8,
wherein a breakdown voltage of the switch element is higher than a breakdown voltage of the control portion.

10. A switching power source device,
wherein the semiconductor integrated circuit device of claim 3 is adopted.
